# EUROPEAN PATENT APPLICATION

(11) **EP 4 750 237 A1**
(43) Date of publication of application: **27.05.2026**
(21) Application number: 24869777.3
(22) Date of filing: 27.05.2024
(51) Int. Cl.: H05K 7/20

(54) **HEAT DISSIPATION ASSEMBLY**

(30) Priority: 27.09.2023 CN 202311262613
(71) Applicant: ZTE CORPORATION, Shenzhen, Guangdong 518057 (CN)
(72) Inventor: HU, Maoxin, Shenzhen, Guangdong 518057 (CN); ZHANG, Shuhan, Shenzhen, Guangdong 518057 (CN); SUN, Weihua, Shenzhen, Guangdong 518057 (CN); NIE, Zhidong, Shenzhen, Guangdong 518057 (CN); CHEN, Haibo, Shenzhen, Guangdong 518057 (CN); LIU, Liemiao, Shenzhen, Guangdong 518057 (CN)
(74) Representative: Ziebig Hengelhaupt Intellectual Property Attorneys Patentanwaltskanzlei PartGmbB
(86) International application number: PCT/CN2024/095500
(87) International publication number: WO 2025/066212

(57) **Abstract**

Provided in the present application is a heat dissipation assembly, which is applied to an electronic device, the electronic device comprising a first substrate and a second substrate arranged opposite to the first substrate, and first components on the first substrate being connected to second components of the second substrate by means of connectors. The heat dissipation assembly comprises a heat dissipation substrate and through hole structures. The heat dissipation substrate is in contact with the first substrate, is used for dissipating heat of the first substrate and is provided with through holes corresponding to the connectors. Each through hole structure comprises a hole pillar corresponding to a through hole, a first sealing cover extending from one end of the hole pillar and a second sealing cover extending from the other end of the hole pillar, the connectors being connected to the first components and the second components by means of the through holes and the hole pillars. Each first sealing cover hermetically coats the connecting area of a connector and a first component, and each second sealing hermetically coats the connecting area of a connector and a second component.

## Description

### CROSS-REFERENCE TO RELATED APPLICATIONS

The present application claims priority to Chinese Application No. 202311262613.8, filed with the Chinese Patent Office on September 27, 2023, with the title "HEAT DISSIPATION ASSEMBLY", the disclosure of which is hereby incorporated by reference in its entirety.

### TECHNICAL FIELD

The present application relates the technical field of heat dissipation for electronic devices, in particular to a heat dissipation assembly.

### BACKGROUND

With the development of electronic devices towards miniaturization, high power, and high integration, the heat generation of components is also constantly increasing.

The technical problem to be solved in the present application is how to achieve better heat dissipation performance under the packaging requirements of small space and high sealing of electronic devices.

### SUMMARY

The purpose of this application is to provide a heat dissipation assembly applied to electronic devices, which can provide better heat dissipation for components in electronic devices under the packaging requirements of small space and high sealing of electronic devices.

In order to achieve the above purpose, the present application provides an embodiment of a heat dissipation assembly applied to electronic devices, the electronic device comprising a first substrate and a second substrate arranged opposite to the first substrate, a first component on the first substrate is connected to a second component on the second substrate by means of a connector, the heat dissipation assembly comprising: a heat dissipation substrate, which is in contact with the first substrate, used for dissipating heat from the first substrate; wherein the heat dissipation substrate is provided with through holes corresponding to the connectors; a through hole structure, comprising a hole pillar corresponding to the through hole, a first sealing cover extending from one end of the hole pillar and a second sealing cover extending from the other end of the hole pillar; wherein the connector is connected to the first component and the second component by means of the through hole and the hole pillar, the first sealing cover hermetically encloses the connection area between the connector and the first component, and the second sealing cover hermetically encloses the connection area between the connector and the second component.

### BRIEF DESCRIPTION OF DRAWINGS

In order to more clearly illustrate the technical solutions in the embodiments of the present application or the prior art, the drawings required for use in the embodiments or the prior art description will be briefly introduced below. Obviously, the drawings described below are only some embodiments of the present application. For those skilled in the art, other drawings can be obtained based on the structures shown in these drawings without creative work.
Fig. 1 is a schematic diagram of a first structure of the heat dissipation assembly according to an embodiment of the present application.
Fig. 2 is a schematic diagram of a second structure of the heat dissipation assembly according to an embodiment of the present application.
Fig. 3 is a schematic diagram of a third structure of the heat dissipation assembly according to an embodiment of the present application.
Fig. 4 is a schematic diagram of a first structure of the heat dissipation assembly under specific implementation of an embodiment of the present application.
Fig. 5 is a schematic diagram of a second structure of the heat dissipation assembly under specific implementation of an embodiment of the present application.
Fig. 6 is a schematic diagram of a third structure of the heat dissipation assembly under specific implementation of an embodiment of the present application.
Fig. 7 is a schematic diagram of a fourth structure of the heat dissipation assembly under specific implementation of an embodiment of the present application.
Fig. 8 is a schematic diagram of a fifth structure of the heat dissipation assembly under specific implementation of an embodiment of the present application.

### DETAILED DESCRIPTION

As electronic devices become smaller and more powerful, how to provide good heat dissipation for internal components under the packaging requirements of small space and high sealing has always been a difficult problem in the industry.

To this end, this application aims to propose a heat dissipation assembly applied to electronic devices, which can achieve relatively optimal heat dissipation and sealing performance with a small space occupation.

In order to enable those skilled in the art to better understand the technical solutions in this specification, the technical solutions in the embodiments of the present application will be described clearly below in conjunction with the drawings in the embodiments of the present application. Obviously, the described embodiments are part of the embodiments of the present application, not all of them. Based on the embodiments in the present application, all other embodiments obtained by those skilled in the art belong to the protection scope of the present application.

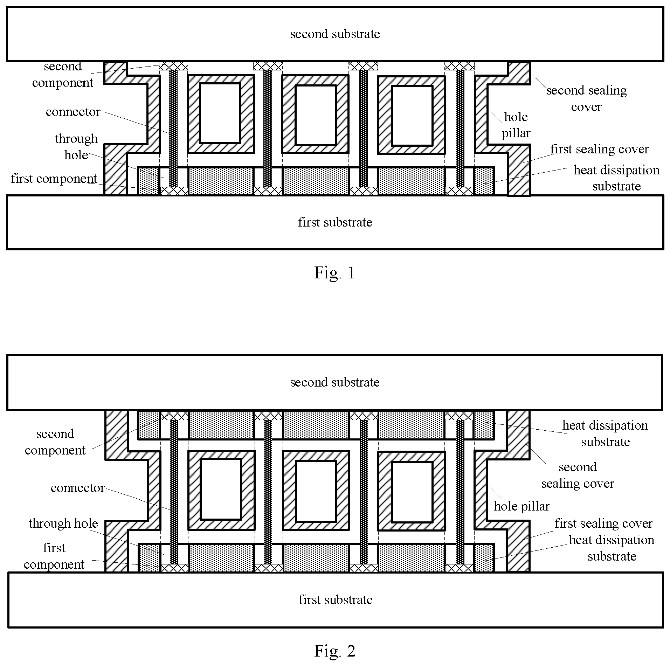

As shown in Fig. 1, the electronic device of the present application adopts a multi substrate structure, comprising a first substrate and a second substrate arranged opposite to it. A first component on the first substrate is connected to a second component on the second substrate by means of a connector. Correspondingly, the heat dissipation assembly of the present application comprises a heat dissipation substrate and a through hole structure.

The heat dissipation substrate is in contact with the first substrate and is used to dissipate heat from the first substrate (including the first component). In addition, the heat dissipation substrate is provided with through holes corresponding to the connectors, and the connectors need to penetrate the through holes of the heat dissipation substrate to connect the first and second components.

The through hole structure comprises a hole pillar corresponding to the through hole, a first sealing cover extending from one end of the hole pillar, and a second sealing cover extending from the other end of the hole column. The hole pillar, the first sealing cover, and the second sealing cover can be integrally formed using die-casting technology.

Wherein the connector is connected to the first substrate and the second substrate by means of the heat dissipation substrate and the through hole structure. The first sealing cover hermetically encloses the connection area between the connector and the first component, and the second sealing cover hermetically encloses the connection area between the connector and the second component.

Based on Fig. 1, the embodiment can integrate the main heat generating component (i.e. the first component) onto the first substrate, and the heat dissipation substrate is responsible for dissipating heat from the first component. At the same time, the first component, the second component, and connector that require electrical connection are completely sealed by an integrated through hole structure, thus meeting the packaging requirements of electronic devices in small spaces.

It should be understood that, in the embodiment, there can be a plurality of connectors. That is, the hole pillars corresponding to the connectors one by one, and both the first sealing cover and the second sealing cover are integrated and extended by the plurality of hole pillars. Based on the design of this through hole structure, each hole pillar is in contact with the first substrate by means of the first sealing cover, and in contact with the second substrate by means of the second sealing cover. The sealing performance of its through hole structure depends only on the connection between the first sealing cover and the first substrate, as well as the connection between the second sealing cover as a whole and the second substrate. If each hole pillar is directly in contact with the first substrate and the second substrate, it is difficult to ensure the stability of the seal. For example, the number of the hole pillars is 10, and the upper and lower end faces of the hole pillars add up to 20, if one of these 20 end faces has a poor connection, it will damage the sealing performance of the entire through hole structure.

The heat dissipation component of this embodiment is applied to any electronic device that can adopt a multi substrate structure. For example, base station antenna devices, mobile phones, PADs, and so on. Taking the base station antenna device as an example, the main heat generating components of the base station (such as transceiver chips, power supplies, filters, and power amplifiers) can be placed on the first substrate for heat dissipation by the heat dissipation substrate; components with low or no heat generation from the base station (such as transmitting and receiving antennas) can be placed on the second substrate.

It should be noted that the structure shown in Fig. 2 is only used as an example to introduce the heat dissipation assembly of this embodiment. In practical applications, if the second component on the second substrate also has a heat dissipation requirement, the heat dissipation assembly can refer to Fig. 2 and a corresponding heat dissipation substrate can be set on the second substrate.

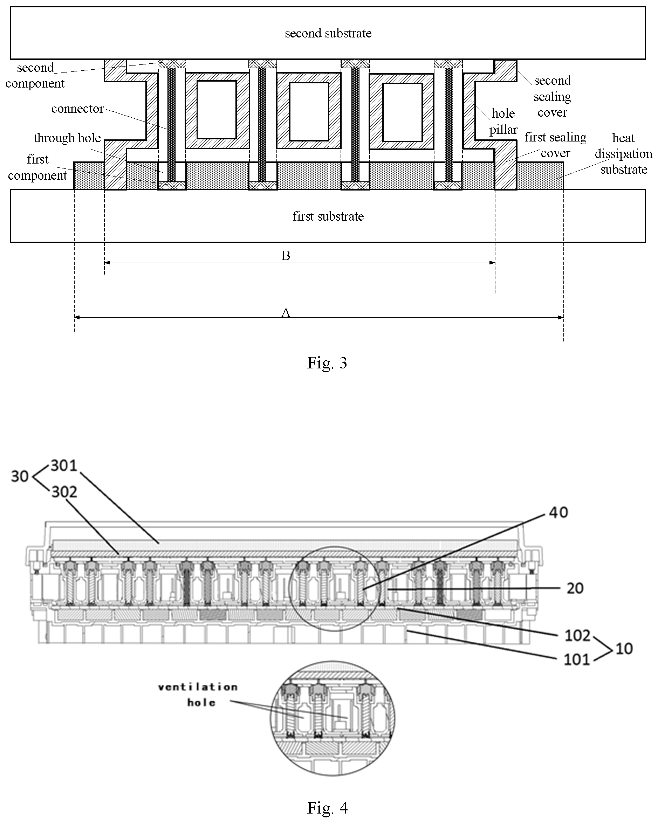

In addition, if the heat dissipation area of the first substrate is large, the heat dissipation substrate can be appropriately set to be larger. For example, as shown in Fig. 3, the projection A formed by the heat dissipation substrate on the first substrate covers the projection B formed by the first sealing cover on the first substrate. The heat dissipation substrate and the through hole structure are independent structures from each other, and the heat dissipation substrate is provided with a hollowed-out area that matches the contour of the first sealing cover. The first sealing cover penetrates the heat dissipation substrate through the hollowed-out area to make contact with the first substrate. Based on the structure shown in Fig. 3, on the basis of a proper increase in the area of the heat dissipation substrate, the sealing performance of the through hole structure can still be ensured.

Below is a detailed introduction to the actual application structure of the heat dissipation assembly in this embodiment.

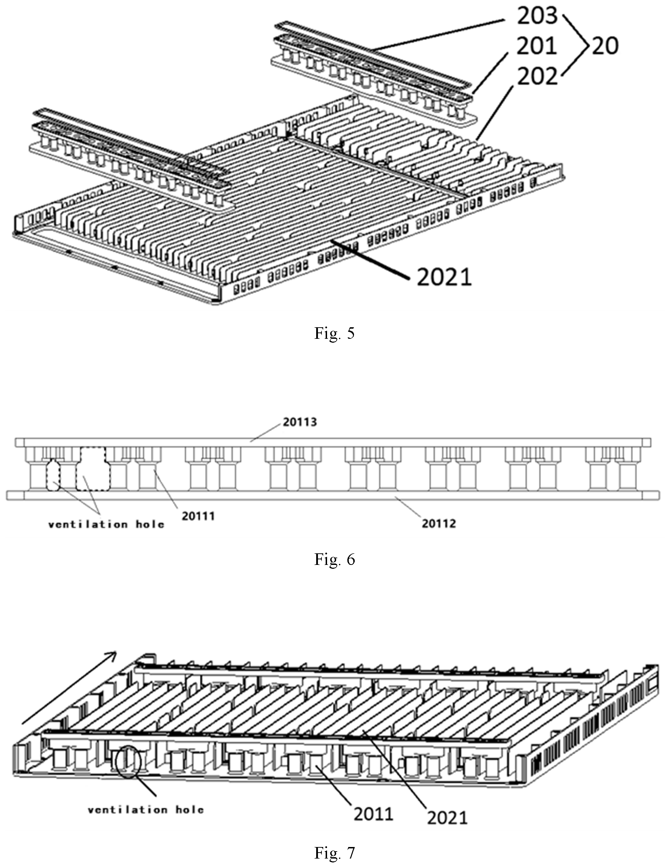

Referring to Figs. 4 and 5, the electronic device of this embodiment mainly comprises: a first substrate 10, a heat dissipation assembly 20, and a second substrate 30. The first substrate 10 is in contact with the second substrate 30 by means of the heat dissipation assembly 20. Wherein:
The first substrate 10 comprises a shell unit 101 and a single board unit 102 equipped with components; the second substrate 30 comprises a protective shell 301 and a single board unit 302 equipped with components. The single board unit 102 and the single board unit 302 transmit signals by means of a connector 40; the heat dissipation component 20 connects the first substrate 10 and the second substrate 30, and can dissipate heat from the components on the single board unit 102 of the first substrate.

The heat dissipation assembly consists of a through hole structure 201, a heat dissipation substrate 202, and a sealing ring (or sealant) 203. Wherein: the heat dissipation substrate 202 is equipped with multiple heat dissipation teeth 2021 arranged at intervals to increase the heat dissipation efficiency of the components on the single board unit 102. As shown in Fig. 6, the through hole structure 201 comprises a hole pillar 20111, a first sealing cover 20112 extending from one end of the hole pillar 20111, and a second sealing cover 20113 extending from the other end of the hole pillar 20111. The cross-section of the hole pillar 20111 is in an I-shape to enhance the support of the through hole structure 201 for the first substrate 10 and the second substrate 30. The sealing ring 203 is assembled on the upper part of the through hole structure 201, that is, the second sealing cover is in pressure contact with the second substrate by means of the sealing ring 203 to achieve waterproofing between the internal channel of the hole pillar 20111 and the second substrate 30. Similarly, the first sealing cover 20112 can also be in pressure contact with the first substrate 10 by means of the sealing ring 20, which will not be further elaborated here.

It should be noted that the end face where the second sealing cover 20113 is connected to the second substrate 30 is an integrated whole (the first sealing cover connected to the first substrate will not be repeated), so only one sealing ring 20 needs to be configured to complete the compression. That is, the sealing performance between the second sealing cover 20113 and the second substrate 30 depends on the yield rate of this sealing ring 20. If each hole pillar 20111 is directly in contact with the second substrate 30, a sealing ring 20 must be arranged on the end face connecting each hole pillar 20111 and the second substrate 30 to complete the compression. If any sealing ring 20 on any end face has problems (such as detachment or deformation), it will damage the overall sealing performance of the through hole structure 201. Obviously, the design of the through hole structure 201 in this embodiment can greatly improve the yield rate during production, thus having high practical value.

Referring further to Fig. 7, at least a part of the gap area (i.e. ventilation holes) between the hole pillars 20111 is arranged corresponding to the gap area between the heat dissipation teeth 2021 (the larger the corresponding area of the two gap areas, the better), and the extension direction of multiple heat dissipation teeth 2021 is consistent with the airflow direction of the ventilation holes between the hole pillars 20111 (as indicated by the arrow in Fig. 7), in order to reduce ventilation resistance and effectively improve the heat dissipation efficiency of the heat dissipation teeth 2021. In the case where the cross-section of the hole pillar 20111 is I-shaped, the ventilation holes formed between the hole pillars 20111 are special-shaped window structures with a smaller top and a larger bottom, ensuring that the ventilation area of the ventilation holes is maximized while meeting the assembly space of the connector 40, thereby improving the overall heat dissipation efficiency of the machine. It should be noted that the tooth profile structure of the heat dissipation teeth 2021 can be V-teeth, straight teeth, helical teeth, etc., which are not specifically limited here. But as a preferred solution, the tooth structure of the heat dissipation teeth 2021 should be matched with ventilation holes to avoid increasing ventilation resistance.

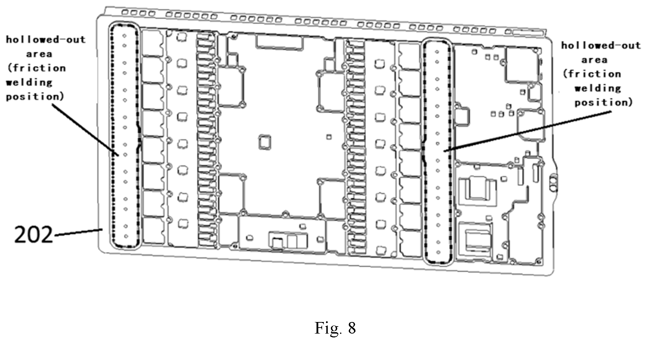

In addition, the through hole structure 201 and the heat dissipation substrate 202 are independent structures from each other that can be formed by glue or laser welding, and no additional sealing treatment is required to achieve the sealing effect. Alternatively, as shown in Fig. 8, the heat dissipation substrate 202 is provided with a hollowed-out area that matches the contour of the first sealing cover 20112. The first sealing cover 20112 penetrates the heat dissipation substrate 202 through the hollowed-out area and is directly sealed and connected to the heat dissipation substrate 202 by means of friction welding process (or cold pressing process), without the need for additional sealing treatment to achieve the sealing effect.

In summary, this application provides a heat dissipation assembly applied to an electronic device. Specifically, this application sets the electronic device as a multi substrate structure. That is, the electronic device comprises a first substrate and a second substrate that are arranged opposite to each other, and the first component on the first substrate is connected to the second component on the second substrate by means of a connector. Wherein the first component on the first substrate is the main heat dissipation object. Correspondingly, the through hole structure comprises a hole pillar, a first sealing cover extending from one end of the hole pillar, and a second sealing cover extending from the other end of the hole pillar. The connector connects the first component and the second component by means of the hole pillar, at the same time, the first sealing cover can hermetically enclose the connection area between the connector and the first component, and the second sealing cover can hermetically enclose the connection area between the connector and the second component, so that the connector, the first component, and the second component are sealed inside the through hole structure. Based on the design of the through hole structure, the first sealing cover and the second sealing cover extending from the hole pillar are in contact with the first substrate and the second substrate, respectively. The sealing performance of the hole pillar depends only on the connection between the first sealing cover and the first substrate, as well as the connection between the second sealing cover and the second substrate. For the structure of the hole pillar, it avoids poor contact between any of the hole pillars and the first substrate and/or the second substrate, which would damage the sealing performance of the entire through hole structure. In addition, the through hole structure can also support the first substrate and the second substrate, which is an indispensable structural design for multi substrate electronic devices. In this way, the entire heat dissipation assembly will not occupy too much content space of the electronic device, and can provide heat dissipation for components under the packaging requirements of small space and high sealing of electronic devices.

The specific embodiments of this specification have been described above. Other embodiments are within the scope of the appended claims. In some cases, the actions or steps described in the claims may be performed in a different order than in the embodiments and still achieve the desired results. In addition, the process depicted in the figures does not necessarily require a specific or continuous order to achieve the desired results. In some implementations, multitasking and parallel processing are also possible or may be advantageous.

The above are only embodiments of this specification and are not intended to limit this specification. For those skilled in the art, this specification can have various changes and variations. Any modifications, equivalent substitutions, improvements, etc. made within the spirit and principles of this specification shall be included within the scope of the claims of this specification. In addition, all other embodiments obtained by those skilled in the art without creative labor should fall within the scope of protection of this document.

## Claims

1. A heat dissipation assembly, applied to an electronic device, the electronic device comprising a first substrate and a second substrate arranged opposite to the first substrate, a first component on the first substrate being connected to a second component on the second substrate by means of a connector, wherein the heat dissipation assembly comprising:
a heat dissipation substrate, which is in contact with the first substrate, used for dissipating heat from the first substrate; wherein the heat dissipation substrate is provided with a through hole corresponding to the connector;
a through hole structure, comprising a hole pillar corresponding to the through hole, a first sealing cover extending from one end of the hole pillar and a second sealing cover extending from the other end of the hole pillar;
wherein the connector is connected to the first component and the second component by means of the through hole and the hole pillar, the first sealing cover hermetically encloses the connection area between the connector and the first component, and the second sealing cover hermetically encloses the connection area between the connector and the second component.

2. The heat dissipation assembly according to claim 1, wherein
there are a plurality of connectors, and the hole pillars correspond to the connectors one by one, both the first sealing cover and the second sealing cover are formed by the common extension of the plurality of hole pillars.

3. The heat dissipation assembly according to claim 1 or 2, wherein
the hole pillar, the first sealing cover, and the second sealing cover are integrally formed.

4. The heat dissipation assembly according to claim 2, wherein
the heat dissipation substrate is equipped with multiple heat dissipation teeth arranged at intervals, and the extension direction of the multiple heat dissipation teeth is consistent with the airflow direction between the hole pillars.

5. The heat dissipation assembly according to claim 4, wherein
at least a part of the gap area between the hole pillars is arranged corresponding to the gap area between the heat dissipation teeth.

6. The heat dissipation assembly according to claim 1, wherein
the heat dissipation substrate and the through hole structure are independent structures from each other, the projection of the heat dissipation substrate formed on the first substrate covers the projection of the first sealing cover formed on the first substrate, the heat dissipation substrate is provided with a hollowed-out area that matches the contour of the first sealing cover, the first sealing cover penetrates the heat dissipation substrate through the hollowed-out area to make contact with the first substrate.

7. The heat dissipation assembly according to claim 6, wherein
the part of the first sealing cover that penetrates the heat dissipation substrate is sealed and connected to the heat dissipation substrate by means of friction welding or cold pressing process.

8. The heat dissipation assembly according to claim 1 or 2, wherein
the cross-section of the hole pillar is in an I-shape.

9. The heat dissipation assembly according to claim 1 or 2, wherein
the first sealing cover is in pressure contact with the first substrate by means of a sealing ring or sealant;
and/or,
the second sealing cover is in pressure contact with the second substrate by means of a sealing ring or sealant.

10. The heat dissipation assembly according to claim 1 or 2, wherein
the second substrate is equipped with a transmitting and receiving antenna, and the first substrate is equipped with a driving device for the transmitting and receiving antenna.
